# EUROPÄISCHE PATENTSCHRIFT

(11) **EP 2 592 403 B1**
(45) Veröffentlichungstag und Bekanntmachung des Hinweises auf die Patenterteilung: **29.03.2017**
(21) Anmeldenummer: 11188414.4
(22) Anmeldetag: 09.11.2011
(51) Int. Cl.: G01K 1/16, H01L 23/34

(54) **Baugruppe mit Temperaturerfassung**
Component with temperature recording
Composant doté d'une détection de température

(43) Veröffentlichungstag der Anmeldung: 15.05.2013
(73) Patentinhaber: Siemens Aktiengesellschaft, 80333 München (DE)
(72) Erfinder: Gläser, Thomas, 91341 Röttenbach (DE); Schwesig, Günter, 91054 Erlangen (DE)

(56) Entgegenhaltungen:
- EP-A2- 1 369 915
- JP-A- 2000 091 884
- US-A- 4 990 987
- US-B1- 7 079 972

## Beschreibung

Die Erfindung betrifft eine Baugruppe mit Temperaturerfassung, umfassend ein Bauelement, ein dem Bauelement thermisch angekoppeltes Wärmeabfuhrelement und einen Temperatursensor zur Erfassung einer Temperatur am Bauelement.

Elektrische Bauelemente sind üblicherweise durch einen zulässigen Umgebungstemperaturbereich spezifiziert. Innerhalb dieses Temperaturbereichs garantieren die Hersteller die beispielsweise in Datenblättern für das jeweilige Bauelement angegebenen charakteristischen Kenngrößen. Die für eine elektronische Baugruppe verwendeten Bauelemente weisen üblicherweise denselben zulässigen Umgebungstemperaturbereich auf.

Zur Überwachung des zulässigen Umgebungstemperaturbereiches wird beispielsweise ein Temperatursensor auf der Leiterplatte oder in der Nähe der Leiterplatte platziert. Überschreitet die erfasste Umgebungstemperatur einen bestimmten Wert, so werden entsprechende Aktionen ausgelöst, um ein Überhitzen der elektrischen Bauelemente der Bauteilgruppe zu verhindern.

Will man betriebsmäßig hohe Umgebungstemperaturen zulassen, für die bestimmte Bauelemente nicht spezifiziert oder nicht verfügbar sind, so müssen diese Bauelemente gekühlt werden, und weisen demzufolge eine eigene Temperatur auf, die insbesondere von der Umgebungstemperatur abweichen wird. Über einen auf der Leiterplatte oder in der Nähe der Leiterplatte montierten Temperatursensor ist insofern eine Überwachung der Temperatur des gekühlten Bauelements nicht mehr möglich.

Der geschilderte Anwendungsfall besteht beispielsweise dann, wenn die Bauteilgruppe in der Nähe von elektrischen Verbrauchern angeordnet ist, die eine Verlustleistung aufweisen und sich infolge dessen während des Betriebs erhitzen. Ein solcher elektrischer Verbraucher ist insbesondere ein elektrischer Motor. Die in der Nähe anzuordnende Bauteilgruppe ist bspw. eine Schaltungsanordnung zur lokalen Ansteuerung des Motors, die zur Ablaufsteuerung ASICs oder Mikro-Controller als Bauelemente umfassen. ASICs und Mikro-Controller sind üblicherweise für höhere Betriebstemperaturen nicht spezifiziert, da dann ihre jeweilige Funktion nicht mehr gewährleistet ist. Die Gewährleistung der in ASICs oder in Mikro-Controllern implementierten Funktionen ist jedoch in aller Regel für die Schaltungsanordnung und für den Betrieb eines angeschlossenen Verbrauchers sicherheitsrelevant.

Aus der US 4,990,987 ist eine Vorrichtung zum Schutz von Halbleiterbauelementen bekannt, die anfällig für Schäden durch Überhitzung sind. Hierzu offenbart die D1 eine wärmeerzeugende Halbleiteranordnung, die ein Bauelement in Form eines Halbleitergehäuses bzw. einer Halbleiterpackung, einen sich vom Halbleitergehäuse weg ersttreckenden, ein Wärmeabfuhrelement bildenden Befestigungsstreifen und einen auf dem Befestigungsstreifen angeordneten PTC Widerstand umfasst. Der PTC Widerstand dient hierbei der Temperaturbestimmung des Halbleitergehäuses durch eine Erhöhung des elektrischen Widerstands bei zunehmender Temperatur.

Weiter ist aus der US 7,079,972 B1 eine Vorrichtung und eine entsprechende Methode zur Temperaturkontrolle integrierter Schaltungen bekannt. Die Vorrichtung umfasst hierbei zwei Widerstände sowie ein wärmeleitfähiges Material auf der Leiterplatte, wobei das wärmeleitfähige Material sowohl mit beiden Widerständen als auch mit der Oberfläche einer die integrierte Schaltung beinhaltende Packung verbunden ist. Das leitfähige Material ist hierbei zwischen der integrierten Schaltung und der Leiterplatte festgelegt. Gemäß der US 7,079,972 B1 ist hierbei der erste Widerstand an einer Seite der integrierten Schaltung auf der Leiterplatte, und der zweite Widerstand auf der gegenüberliegenden Seite der integrierten Schaltung auf der Leiterplatte festgelegt. Eine solche Vorrichtung dient der Steuerung der Betriebstemperatur von elektronischen Komponenten.

Die EP 1 369 915 A2 offenbart ein Halbleiterbauelement mit einer integrierten Schaltung. Das Halbleiterbauelement weist einen Kühlkörper als Wärmesenke sowie einen damit thermisch verbundenen Temperatursensor auf, dessen Widerstand von der Temperatur abhängig ist. Um eine genaue und rasche Temperaturermittlung bei der Wärmeabfuhr aus integrierten Schaltungen im Bereich der Wärmesenke eines Halbleiterschaltelements vorzunehmen, weist der Temperatursensor einen Dünnfilm-Messwiderstand auf, der auf einer elektrisch isolierenden Oberfläche eines folienartigen Substrats aufgebracht ist, wobei die gesamte Dicke des Temperatursensors im Bereich von 10 µm bis 100 µm liegt und wobei der Temperatursensor an den Kühlkörper thermisch angekoppelt ist.

Weiter ist aus der JP 2000 091 884 A eine elektronische Schaltungsanordnung mit einem auf einer Leiterplatte angeordneten Heizelement bekannt. Die Leiterplatte und das Heizelement sind hier mittels einer Schraube auf einem Wärmeabfuhrelement befestigt. Weiter umfasst die elektronische Schaltungsanordnung einen Temperatursensor, der über ein Klemmenpaar mit der Leiterplatte kontaktiert ist.

Es ist Aufgabe der Erfindung, eine Baugruppe mit Temperaturerfassung anzugeben, wobei insbesondere bei vorgesehener Kühlung eines Bauelements dessen Betriebstemperatur möglichst einfach und sicher erfasst werden kann.

Diese Aufgabe wird für eine Baugruppe, umfassend ein Bauelement, ein dem Bauelement thermisch angekoppeltes Wärmeabfuhrelement und einen Temperatursensor zur Erfassung einer Temperatur am Bauelement, erfindungsgemäß dadurch gelöst, dass zwischen dem Bauelement und dem Wärmeabfuhrelement eine Leiterplatte mit Durchkontaktierungen eingelegt ist, dass der Temperatursensor auf der Leiterplatte angeordnet und elektrisch über die Leiterplatte kontaktiert ist, und dass der Temperatursensor innerhalb der projizierten Querschnittsfläche des Bauelements positioniert ist.

Die Erfindung geht dabei in einem ersten Schritt von der Überlegung aus, dass zur Überwachung eines gekühlten temperaturempfindlichen Bauelements die Erfassung der Umgebungstemperatur keine Aussage über die Temperatur des Bauelements selbst zulässt. Vielmehr sollte die Temperatur des Bauelements unmittelbar gemessen werden können.

Dazu könnte beispielsweise in den Wärmefluss zwischen Bauelement und Wärmeabfuhrelement ein Messhilfsmittel mit hoher Wärmeleitfähigkeit, wie beispielsweise ein Kupferkörper, integriert und die Temperatur des Messhilfsmittels bestimmt werden. Ein derartiges Messhilfsmittel kann sich vom Bauelement weg erstrecken, so dass dort die Temperatur mittels eines Temperatursensors entweder direkt oder über Wärmestrahlung gemessen werden. Die am Messhilfsmittel ermittelte Temperatur wäre dann ein Maß für die Temperatur des Bauelements.

Das Messhilfsmittel muss allerdings zu einer solchen Temperaturerfassung ein gewisses Volumen aufweisen, was Nachteile für die mechanische Stabilität der Baugruppe hat. Eine mechanische Ankopplung des Messhilfsmittels an die Leiterkarte, auf welcher das Bauelement selbst befestigt ist, führt aber zu einer mechanischen Überbestimmtheit. Andererseits stellt ein Temperatursensor zur strahlenden Erfassung der Temperatur ein kostenintensives Bauteil dar. Ein solcher Temperatursensor ist zudem empfindlich gegenüber Verschmutzung und Betauung. Das entsprechend dimensionierte Messhilfsmittel kann sich zudem in unerwünschter Weise bei einer mechanischen Belastung durch Rütteln oder Stoß vom Bauelement lösen.

In einem zweiten Schritt geht die Erfindung von der Überlegung aus, die genannten Nachteile der angedachten Lösungen dadurch zu vermeiden, dass der Temperatursensor unmittelbar in den Wärmefluss zwischen Bauelement und Wärmeabfuhrelement einbezogen wird. Dies gelingt dadurch, dass zwischen dem Bauelement und dem Wärmeabfuhrelement eine Leiterplatte mit Durchkontaktierungen eingelegt ist, wobei der Temperatursensor auf der Leiterplatte angeordnet und elektrisch über die Leiterplatte kontaktiert ist. Dabei ist der thermische Kontakt zwischen dem Bauelement und dem Wärmeabfuhrelement über die Durchkontaktierungen der Leiterplatte gewährleistet. Derartige Durchkontaktierungen sind Durchgangsöffnungen in der Leiterplatte, wobei die Wände der Durchgangsöffnungen zur elektrischen und damit auch zur thermischen Kontaktierung mit einem metallischen Leiter belegt sind. Die Öffnungen können auch ganz mit einem metallischen Leiter ausgefüllt sein.

Dadurch, dass der Temperatursensor auf der Leiterplatte angeordnet ist, die in den Wärmefluss zwischen Bauelement und Wärmeabfuhrelement integriert ist, ist eine unmittelbare Erfassung der Temperatur des Bauelements möglich. Als Temperatursensor kann beispielsweise ein kostengünstiger Kontaktsensor verwendet werden, dessen elektrische Versorgung und dessen Signalabgriff gleichermaßen über die Leiterplatte gewährleistet werden kann.

Dadurch, dass der Temperatursensor auf der Leiterplatte angeordnet und über diese elektrisch kontaktiert ist, brauchen zum Abgriff nur entsprechende Leiterbahnen der Leiterplatte kontaktiert werden, um die Temperatur des Bauelements erfassen zu können. Dabei geht die Erfindung davon aus, dass die Leiterplatte aufgrund ihrer Lage zwischen Bauelement und Wärmeabfuhrelement eine der Temperatur des Bauelements entsprechende Temperatur einnimmt.

Eine mechanische Überbestimmtheit wird vermieden, da die Leiterplatte abgesehen von ihrer Befestigung auf dem Bauelement keine weitere mechanische Ankopplung oder Befestigung benötigt. Weiter kann die Leiterplatte möglichst dünn ausgestaltet werden, da die Temperaturerfassung unmittelbar erfolgt. Wird die Leiterplatte dünn ausgeführt, so ist auch der Wärmeabfluss vom Bauelement nicht beeinflusst.

In einer bevorzugten Ausgestaltung ist die Leiterplatte als eine flexible Leiterplatte ausgebildet. Derartige Leiterplatten sind folienartig ausgebildet und bis zu Dicken unterhalb von 0,25 mm erhältlich. Als Träger der Leiterbahnen ist beispielsweise ein Polyimid bekannt. Eine flexible Leiterplatte bietet abgesehen von ihrer geringen Dicke den weiteren Vorteil, dass sie aufgrund ihrer Flexibilität in der Lage ist, sich der Oberfläche des Bauelements möglichst plan aufzulegen, wodurch die Wärmeabfuhr über die Leiterplatte verbessert ist.

Zweckmäßigerweise ist die Leiterplatte beidseitig zumindest abschnittsweise mit einer Leiterfläche belegt, in der die Durchkontaktierungen angeordnet sind. Auch hierdurch wird die Wärmeabfuhr verbessert, da die Temperatur über die Leiterfläche gleichverteilt und über die Durchkontaktierungen parallel abgeführt wird.

Zum elektrischen Anschluss des Temperatursensors ist die Leiterplatte bevorzugt mit einem seitlich das Bauelement überragenden Anschlussstück ausgebildet, auf welches die Anschlussleitungen des Temperatursensors geführt sind. Auf einem solchen Anschlussstück ist zweckmäßigerweise ein mit den Anschlussleitungen kontaktierter Stecker montiert. Dieser Stecker kann beispielsweise mit einem Gegenstecker verbunden werden, der wiederum mit einer Leiterkarte einer Bauteilgruppe kontaktiert ist.

Der Temperatursensor ist innerhalb der projizierten Querschnittsfläche des Bauelements positioniert, wofür in dem Wärmeabfuhrelement eine entsprechende Aussparung angeordnet ist. Je nach Art des Wärmeabfuhrelements kann eine solche Aussparung bereits grundsätzlich vorhanden sein. Das Wärmeabfuhrelement kann auch mehrteilig oder mit mehreren Kontaktbrücken zum Bauelement ausgestaltet sein, so dass der Temperatursensor in einem entsprechenden Zwischenraum angeordnet werden kann. Bevorzugt ist der Temperatursensor bezüglich der Querschnittsfläche des Bauelements etwa mittig platziert.

Vorteilhafterweise ist zur Wärmekopplung zwischen dem Wärmeabfuhrelement und der Leiterplatte ein elastisch verformbares Wärmeleitpad eingelegt. Ein solches Wärmeleitpad gleicht Höhenunterschiede, Toleranzen und Oberflächenrauhigkeiten sowie insbesondere auch mechanische Bewegungen gegeneinander aus und verbessert insofern die Wärmeabfuhr aus dem Bauelement.

Das Wärmeabfuhrelement selbst kann ein Kühlkörper sein. Im Sinne der Erfindung kann das Wärmeabfuhrelement auch als ein aktiver Lüfter verstanden werden. In einer zweckmäßigen Ausgestaltung ist das Wärmeabfuhrelement ein Baugruppengehäuse. Mit anderen Worten ist das Bauelement unter Zwischenlage der Leiterplatte thermisch mit dem Baugruppengehäuse verbunden, über welches die Wärme aus dem Bauelement abgeführt wird.

Die Leiterplatte kann auf das Bauelement und mit dem Wärmeabfuhrelement verklebt sein.

Ist das Wärmeabfuhrelement als ein Baugruppengehäuse gegeben, so ist in einer bevorzugten Ausgestaltung die Leiterkarte, auf der das Bauelement montiert ist, mechanisch mit dem Baugruppengehäuse verspannt. Auf diese Weise wird die Leiterplatte mit dem Temperatursensor sicher zwischen den Baugruppengehäuse und dem Bauelement gehalten. Gegebenenfalls kann auf eine zusätzliche stoffschlüssige Verbindung verzichtet werden. Zur Unterstützung kann jedoch eine Klebung hinzugefügt sein.

In einer weiter bevorzugten Ausgestaltung ist der Temperatursensor als ein I²C-Sensor ausgebildet. Ein solcher Sensor liefert ausgangsseitig digitale Signale, so dass die Temperaturerfassung insgesamt weniger empfindlich gegenüber Störstrahlung ist.

Die Erfindung lässt sich grundsätzlich auf beliebige Objekte oder Bauelemente übertragen. Sollte die Oberfläche eines derartigen Objekts oder Bauelements elektrisch leitend sein, so ist ein elektrisch isolierender Lack oder eine elektrische Isolierfolie zwischen der Leiterplatte und der Objekt- oder Bauelementoberfläche vorzusehen.

Ausführungsbeispiele der Erfindung werden anhand einer Zeichnung näher erläutert. Dabei zeigen:
- FIG 1: in einem Querschnitt eine Baugruppe mit Temperaturerfassung und
- FIG 2: in einer Aufsicht eine Leiterplatte mit Durchkontaktierungen zur Erfassung der Oberflächentemperatur eines Bauelements

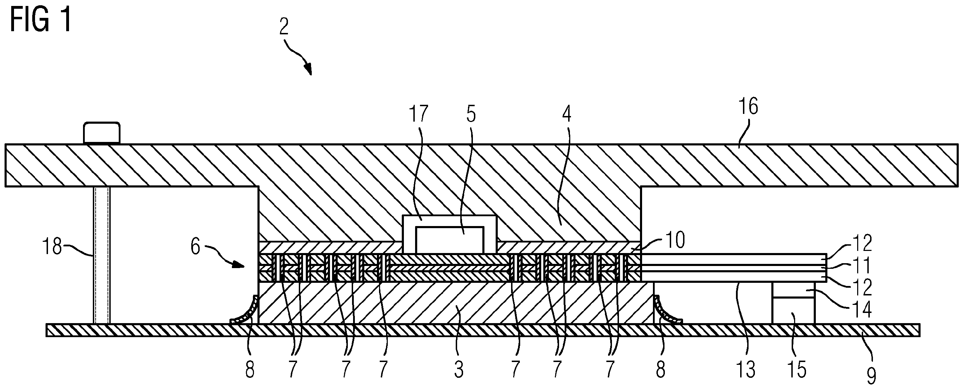

In einer Schnittdarstellung zeigt FIG 1 den Aufbau einer Baugruppe 2, die ein temperaturempfindliches Bauelement 3, ein Wärmeabfuhrelement 4 sowie einen Temperatursensor 5 umfasst.

Das Bauelement 3 soll in hohen Umgebungstemperaturbereichen betrieben werden, für welche es herstellerseitig nicht spezifiziert ist. Aus diesem Grund ist das Bauelement 3 thermisch mit dem Wärmeabfuhrelement 4 gekoppelt, um die Temperatur des Bauelements 3 selbst relativ niedrig halten zu können. Das Bauelement 3 ist beispielsweise ein ASIC oder ein Mikro-Controller und Teil einer Motorsteuerung, die unmittelbar an einem elektrischen Motor als Verbraucher montiert ist.

Zur Überwachung der Oberflächentemperatur des Bauelements 3 ist zwischen dem Bauelement 3 und dem Wärmeabfuhrelement 4 eine Leiterplatte 6 eingelegt, die eine Vielzahl von Durchkontaktierungen 7 umfasst. Die Durchkontaktierungen 7 sind als Durchgangsöffnungen gegeben, deren Wände jeweils mit einem metallischen Leiter belegt sind. Die Öffnungen können auch vollflächig mit Leitermaterial ausgefüllt sein. Über die Durchkontaktierungen 7 weist die Leiterplatte 6 in dieser Richtung eine hohe thermische Leitfähigkeit auf, so dass die Wärmeabfuhr zwischen den Bauelement 3 und dem Wärmeabfuhrelement 4 gewährleistet ist bzw. bleibt. Die thermische Anbindung der Leiterplatte 6 zum Wärmeabfuhrelement 4 geschieht über ein zwischengelegtes Wärmeleitpad 10.

Der Temperatursensor 5 ist als ein Kontaktsensor ausgebildet und bezüglich des Querschnitts des Bauelements 3 etwa mittig auf der Leiterplatte 6 montiert und elektrisch über die Leiterplatte 6 kontaktiert. Das Bauelement 3 ist als Teil einer Bauteilgruppe über Anschlussbeine 8 auf einer Leiterkarte 9 montiert.

Die Leiterplatte 6 ist als eine flexible Leiterplatte ausgebildet und umfasst einen Träger 11 aus Polyimid, dem beidseits Leiterbahnen beziehungsweise Leiterflächen 12 aufgebracht sind. Über ein seitlich das Bauelement 3 überragendes Anschlussstück 13 sind die den Temperatursensor 5 kontaktierenden Leiterbahnen nach außen geführt und dort mit einem Stecker 14 kontaktiert. Der Stecker 14 ist mit einem Gegenstecker 15 verbunden, der wiederum auf der Leiterkarte 9 montiert ist.

Das Wärmeabfuhrelement 4 ist vorliegend als ein Baugruppengehäuse 16 gegeben. Das Baugruppengehäuse 16 weist eine Aussparung 17 auf, in die der Temperatursensor 5 angeordnet ist.

Die Leiterkarte 9 ist auf der Außenseite eines nicht gezeigten elektrischen Motors montiert und über eine Schraubverbindung 18 mechanisch mit dem Baugruppengehäuse 16 verbunden. Über die hierdurch realisierte mechanische Vorspannung sind die Leiterplatte 6 sowie das Wärmeleitpad 10 mechanisch mit dem Baugruppengehäuse 16 verbunden. Unterstützend sind Bauelement 3, Leiterplatte 6, Wärmeleitpad 10 und Baugruppengehäuse 16 miteinander verklebt.

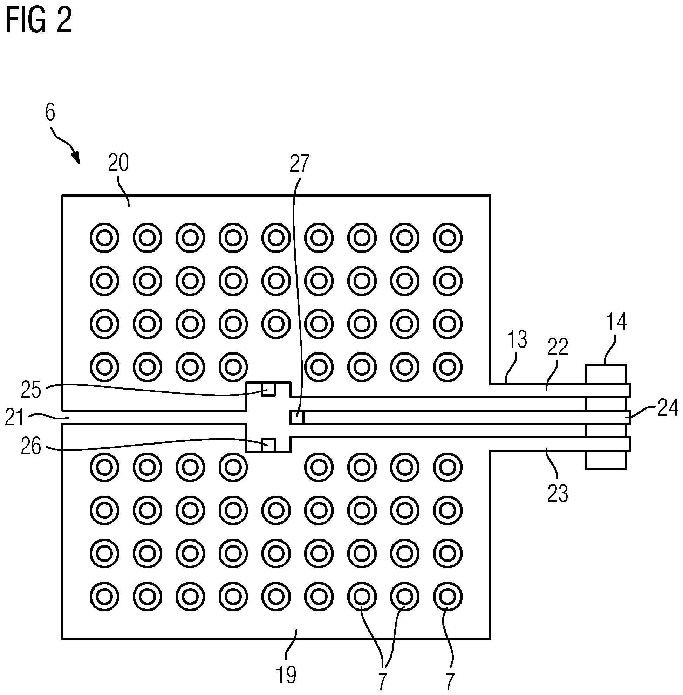

In FIG 2 ist eine Aufsicht auf die Leiterplatte 6 entsprechend FIG 1 gezeigt. Dabei ist die Seite dargestellt, auf der der Temperatursensor 5 angeordnet ist. Die Oberseite der Leiterplatte 6 weist zwei getrennte Leiterflächen 19 und 20 auf, die einen Zwischenraum 21 zueinander bilden. Die nicht dargestellte Rückseite der Leiterplatte 6 ist entsprechend mit einem metallischen Leiter belegt. Über die Durchkontaktierungen 7 sind die jeweiligen Leiterflächen 20, 21 mit der Leiterfläche auf der Rückseite sowohl elektrisch als auch thermisch kontaktiert.

Die Leiterflächen 20 und 21 dienen zur elektrischen Versorgung des in der Mitte der Leiterplatte 6 zu positionierenden Temperatursensors 5. Dazu sind die Leiterflächen 19 und 20 über eine jeweils zugeordnete erste Anschlussbahn 22 und zweite Anschlussbahn 23 auf das seitliche Anschlussstück 13 geführt und dort mit dem Stecker 14 kontaktiert.

Auf dem Anschlussstück 13 ist weiter eine dritte Anschlussbahn 24 angeordnet, die ebenfalls mit dem Stecker 14 kontaktiert ist. Mittig bilden die Leiterflächen 19 und 20 einen ersten Versorgungsanschluss 25 und einen zweiten Versorgungsanschluss 26 für den Temperatursensor 5 aus. Über den mit der dritten Anschlussbahn 24 elektrisch verbundenen Signalausgang 27 wird ein Temperaturwert am Ausgang des Temperatursensors 5 abgegriffen.

## Patentansprüche

1. Baugruppe (2) mit Temperaturerfassung, umfassend ein Bauelement (3), ein dem Bauelement (3) thermisch angekoppeltes Wärmeabfuhrelement (4) und einen Temperatursensor (5) zur Erfassung einer Temperatur am Bauelement (3), wobei zwischen dem Bauelement (3) und dem Wärmeabfuhrelement (4) eine Leiterplatte (6) mit Durchkontaktierungen (7) eingelegt ist, und wobei der Temperatursensor (5) auf der Leiterplatte (6) angeordnet und elektrisch über die Leiterplatte (6) kontaktiert ist, **dadurch gekennzeichnet, dass** der Temperatursensor (5) innerhalb der projizierten Querschnittsfläche des Bauelements (3) positioniert ist.

2. Baugruppe (2) nach Anspruch 1, **dadurch gekennzeichnet, dass** die Leiterplatte (6) eine flexible Leiterplatte ist.

3. Baugruppe (2) nach Anspruch 1 oder 2, **dadurch gekennzeichnet, dass** die Leiterplatte (6) eine Dicke von weniger als 0,25 mm aufweist.

4. Baugruppe (2) nach einem der vorhergehenden Ansprüche, **dadurch gekennzeichnet, dass** die Leiterplatte (6) beidseitig zumindest abschnittsweise mit einer Leiterfläche (20) belegt ist, in der die Durchkontaktierungen (7) angeordnet sind.

5. Baugruppe (2) nach einem der vorhergehenden Ansprüche, **dadurch gekennzeichnet, dass** die Leiterplatte (6) mit einem seitlich das Bauelement (3) überragenden Anschlussstück (13) ausgebildet ist, auf welches die Anschlussleitungen (22,23,24) des Temperatursensors (5) geführt sind.

6. Baugruppe (2) nach Anspruch 5, **dadurch gekennzeichnet, dass** auf dem Anschlussstück (13) ein mit den Anschlussleitungen (22,23,24) kontaktierter Stecker (14) montiert ist.

7. Baugruppe (2) nach einem der vorhergehenden Ansprüche, **dadurch gekennzeichnet, dass** der Temperatursensor (5) in einer Aussparung (17) des Wärmeabfuhrelements (4) angeordnet ist.

8. Baugruppe (2) nach einem der vorhergehenden Ansprüche, **dadurch gekennzeichnet, dass** zwischen dem Wärmeabfuhrelement (4) und der Leiterplatte (6) ein elastisch verformbares Wärmeleitpad (10) eingelegt ist.

9. Baugruppe (2) nach einem der vorhergehenden Ansprüche, **dadurch gekennzeichnet, dass** das Wärmeabfuhrelement (4) ein Baugruppengehäuse (16) ist.

10. Baugruppe (2) nach Anspruch 9, **dadurch gekennzeichnet, dass** das Bauelement (3) als Teil einer Schaltungsanordnung auf einer Leiterkarte (9) montiert ist, und dass die Leiterkarte (9) mit dem Baugruppengehäuse (16) unter thermischer Ankopplung des Bauelements (3) mechanisch verspannt ist.

11. Baugruppe (2) nach einem der vorhergehenden Ansprüche, **dadurch gekennzeichnet, dass** der Temperatursensor (5) ein I²C-Sensor ist.

## Claims

1. Component (2) having temperature recording, comprising a module (3), a heat dissipation element (4) thermally coupled to the module (3) and a temperature sensor (5) for recording a temperature on the module (3), wherein a circuit board (6) comprising plated-through holes (7) is inserted between the module (3) and the heat dissipation element (4), and wherein the temperature sensor (5) is arranged on the circuit board (6) and is electrically contacted via the circuit board (6), **characterised in that** the temperature sensor (5) is positioned inside the projected cross-sectional surface of the module (3).

2. Component (2) according to claim 1, **characterised in that** the circuit board (6) is a flexible circuit board.

3. Component (2) according to claim 1 or 2, **characterised in that** the circuit board (6) has a thickness of less than 0.25 mm.

4. Component (2) according to one of the preceding claims, **characterised in that** the circuit board (6) is populated on both sides at least in sections with a conductor surface (20) in which the plated-through holes (7) are arranged.

5. Component (2) according to one of the preceding claims, **characterised in that** the circuit board (6) is formed with a connection piece (13) projecting laterally over the module (3), onto which connection piece (13) the connection lines (22, 23, 24) of the temperature sensor (5) are guided.

6. Component (2) according to claim 5, **characterised in that** a plug (14) contacted with the connection lines (22, 23, 24) is mounted on the connecting piece (13).

7. Component (2) according to one of the preceding claims, **characterised in that** the temperature sensor (5) is arranged in a recess (17) of the heat dissipation element (4).

8. Component (2) according to one of the preceding claims, **characterised in that** an elastically deformable thermal pad (10) is inserted between the heat dissipation element (4) and the circuit board (6)

9. Component (2) according to one of the preceding claims, **characterised in that** the heat dissipation element (4) is a component housing (16).

10. Component (2) according to claim 9, **characterised in that** the component (3) is mounted as part of a circuit arrangement on a printed circuit card (9), and that the printed circuit card (9) is mechanically clamped to the component housing (16), with thermal coupling of the module (3).

11. Component (2) according to one of the preceding claims, **characterised in that** the temperature sensor (5) is an I²C sensor.

## Revendications

1. Module à détection de la température, comprenant un composant ( 3 ), un élément ( 4 ) d'évacuation de la chaleur couplé thermiquement au composant ( 3 ) et une sonde ( 5 ) de température pour détecter une température du composant ( 3 ), dans lequel il est inséré, entre le composant ( 3 ) et l'élément ( 4 ) d'évacuation de la chaleur, une plaquette ( 6 ) à circuit imprimé ayant des traversées ( 7 ) et la sonde ( 5 ) de température étant montée sur la plaquette ( 6 ) à circuit imprimé et contactée électriquement par l'intermédiaire de la plaquette ( 6 ) à circuit imprimé, **caractérisé en ce que** la sonde ( 5 ) de température est placée à l'intérieur de la projection de la surface de section transversale du composant ( 3 ).

2. Module ( 2 ) suivant la revendication 1, **caractérisé en ce que** la plaquette ( 6 ) à circuit imprimé est une plaquette à circuit imprimé souple.

3. Module ( 2 ) suivant l'une des revendications 1 ou 2, **caractérisé en ce que** la plaquette ( 6 ) à circuit imprimé a une épaisseur de moins de 0,25 mm.

4. Module ( 2 ) suivant l'une des revendications précédentes, **caractérisé en ce que** la plaquette ( 6 ) à circuit imprimé est occupée des deux côtés au moins par endroit par une surface ( 20 ) conductrice dans laquelle sont disposées les traversées ( 7 ).

5. Module ( 2 ) suivant l'une des revendications précédentes, **caractérisé en ce que** la plaquette ( 6 ) à circuit imprimé est constituée en ayant une pièce ( 13 ) de connexion, qui dépasse latéralement du composant ( 3 ) et sur laquelle passent les lignes ( 22, 23 ) de connexion de la sonde ( 5 ) de température.

6. Module ( 2 ) suivant la revendication 5, **caractérisé en ce que** sur la pièce ( 13 ) de connexion est monté un connecteur ( 14 ) contacté par les lignes ( 22, 23, 24 ) de connexion.

7. Module ( 2 ) suivant l'une des revendications précédentes, **caractérisé en ce que** la sonde ( 5 ) de température est disposée dans un évidement ( 17 ) de l'élément ( 4 ) d'évacuation de la chaleur.

8. Module ( 2 ) suivant l'une des revendications précédentes, **caractérisé en ce qu'**un pad ( 10 ) conducteur de la chaleur et déformable élastiquement est inséré entre l'élément ( 4 ) d'évacuation de la chaleur et la plaquette ( 6 ) à circuit imprimé.

9. Module ( 2 ) suivant l'une des revendications précédentes, **caractérisé en ce que** l'élément ( 4 ) d'évacuation de la chaleur est un boîtier ( 16 ) de module.

10. Module ( 2 ) suivant la revendication 9, **caractérisé en ce que** le composant ( 3 ) est monté en tant que partie d'un circuit sur une carte ( 9 ) à circuit imprimé et **en ce que** la carte ( 9 ) à circuit imprimé est bloquée mécaniquement avec couplage thermique du composant ( 3 ) avec le boîtier ( 16 ) du module.

11. Module ( 2 ) suivant l'une des revendications précédentes, **caractérisé en ce que** la sonde ( 5 ) de température est une sonde I²C.
